# EUROPÄISCHE PATENTSCHRIFT

(11) **EP 3 047 930 B1**
(45) Veröffentlichungstag und Bekanntmachung des Hinweises auf die Patenterteilung: **15.05.2019**
(21) Anmeldenummer: 15185068.2
(22) Anmeldetag: 14.09.2015
(51) Int. Cl.: B23K 1/08, B23K 3/06, B23K 1/00

(54) **VORRICHTUNG ZUM LÖTEN VON ELEKTRISCHEN ODER ELEKTRONISCHEN BAUTEILEN**
DEVICE FOR SOLDERING OF ELECTRICAL OR ELECTRONIC COMPONENTS
DISPOSITIF DE SOUDAGE DE COMPOSANTS ELECTRIQUES OU ELECTRONIQUES

(30) Priorität: 29.12.2014 DE 102014119682
(43) Veröffentlichungstag der Anmeldung: 27.07.2016
(73) Patentinhaber: Ersa GmbH, 97877 Wertheim (DE)
(72) Erfinder: VÖLKER, Stefan, 97840 Hafenlohr (DE); SPACHMANN, Egon, 97896 Boxtal (DE)
(74) Vertreter: DREISS Patentanwälte PartG mbB

(56) Entgegenhaltungen:
- WO-A1-95/19864
- DE-T5-112011 100 931
- JP-A- 2004 122 220
- US-A1- 2003 121 950
- US-A1- 2012 024 938

## Beschreibung

Die Erfindung betrifft eine Vorrichtung zum Löten von elektrischen oder elektronischen Bauteilen auf einer Leiterplatte nach dem Oberbegriff des Anspruchs 1 (vergleiche US 2003/0121950 A1).

Vorrichtungen der in Rede stehenden Art dienen überwiegend, jedoch keineswegs ausschließlich, zum Löten von elektronischen Bauteilen auf einer Leiterplatte, bei denen die Lötpins der auf der Oberseite der Leiterplatte oder Platine angeordneten Bauteile die Leiterplatte in Ausnehmungen durchgreifen und zumindest geringfügig über die Unterseite der Platine hervorstehen. Das Verlöten erfolgt dann entweder durch Verfahren der Platine über eine fest angeordnete Lötdüseneinrichtung mit einer aus der Lötdüse austretenden Lotwelle (Wellenlöten) oder aber durch Anfahren der zu lötenden Bereiche durch eine Lötdüsenanordnung mit einer oder mehreren an die jeweiligen Bedingungen angepassten Lötdüsen, aus denen kontinuierlich Lot austritt, wobei die zu lötenden Pins in das Lot eintauchen (Tauchlöten). Da nur ein kleiner Teil des aus den Lötdüsen austretenden schmelzflüssigen Lotes zum eigentlichen Löten Verwendung findet, wird das überschüssige Lot abgeleitet und in den Schmelztiegel zurückgeführt. Fließt oder fällt das Lot nun einfach schwerkraftbeaufschlagt in den Schmelztiegel zurück, besteht die Gefahr der Bildung von Spritzern beim Auftreffen des Lotes auf dem die Lötdüsen fixierenden Träger oder dem Spiegel des schmelzflüssigen Lotes im Tiegel, die, wenn sie an die Unterseite der Leiterplatte gelangen, zu einem funktionellen Ausfall derart gelöteter Baugruppen führen können. Diese Gefahr wird dann noch vergrößert, wenn das Löten unter Schutzgas, insbesondere in Form von Stickstoff, erfolgt, da das flüssiges Lot unter Stickstoffatmosphäre zu starker Kugel- und/oder Spritzerbildung neigt.

Zur Verringerung dieses Problems ist es bekannt, die Lötdüsen mit geneigten Ablauf- oder Leitblechen zu versehen, die für eine kontrollierten Abfluss des überschüssigen Lotes sorgen sollen. Insbesondere bei einer Mehrzahl von eng stehenden Lötdüsen ist die Verwendung solcher Leitbleche nicht möglich.

Ausgehend von diesem Stand er Technik ist es die Aufgabe der vorliegenden Erfindung, eine gattungsgemäße Vorrichtung zu schaffen, die diese Nachteile nicht aufweist.

Diese Aufgabe wird durch eine Vorrichtung nach der Lehre des Anspruchs 1 gelöst.

Vorteilhafte Ausgestaltungen der Erfindung sind Gegenstand der Unteransprüche.

Die Vorrichtung zum Löten von elektrischen oder elektronischen Bauteilen auf einer Leiterplatte weist also in zunächst bekannter Weise eine Lötdüsenanordnung mit mindestens einem Träger auf, auf dem eine Mehrzahl von Lötdüsen angeordnet ist. Der Träger kann dabei auf beliebige Weise ausgebildet sein, beispielsweise als Rahmen oder Platte. Entscheidend dabei ist wesentlich, dass der Träger die Lötdüsen aufnehmen und halten kann. Die Lötdüsenanordnung ist oberhalb eines Schmelz- oder Löttiegels derart angeordnet, dass mittels einer Fördereinrichtung, die beispielsweise eine Lotpumpe und ein Steigrohr aufweisen kann, schmelzflüssiges Lot aus dem Löttiegel durch die Lötdüsen an die zu lötenden Bauteile gefördert wird.

Erfindungsgemäß ist mindestens eine Ableiteinrichtung für aus den Lotdüsen ausgetretenes überschüssiges Lot vorgesehen, die zwischen der Spitze der Lötdüsen und dem Träger angeordnet ist, wobei die Ableiteinrichtung mindestens eine Prallplatte aufweist, die die Lötdüsen im wesentlichen umgreift. Mit anderen Worten bedeutet dies zunächst, dass zwischen der Spitze der Lötdüsen und dem Träger und damit auch zwischen der Spitze der Lötdüsen und dem Spiegel des schmelzflüssigen Lotes im Schmelztiegel eine Trennebene eingezogen wird, welche die Fallhöhe des Lotes und damit dessen kinetische Energie reduziert, so dass eine Spritzerbildung verhindert oder zumindest reduziert wird. Dadurch, dass die Prallplatte die Lötdüse im wesentlichen umgreift, ist es grundsätzlich unerheblich, an welcher Seite der Lötdüse der Abfluss des Lotes erfolgt. Erfolgt nun ein weiteres Ableiten des Lotes von der Prallplatte in den Schmelztiegel, wird eine eventuelle Spritzerbildung durch die Unterseite der Prallplatte gegenüber der Unterseite der Leiterplatte abgeschirmt.

Vorzugsweise umgreift die Prallplatte die Lötdüsen im Wesentlichen formschlüssig, so dass eine Dichtwirkung zwischen Prallplatte und Lötdüsen erreicht werden kann.

Die Prallplatte kann als Prallplatteneinrichtung mit einer Mehrzahl von Plattensegmenten ausgebildet sein, die insgesamt in zusammengebautem Zustand die Prallplatte bilden. Vorzugsweise jedoch ist die Prallplatte im wesentlichen einstückig ausgebildet und weist eine Mehrzahl von Ausnehmung auf, die von den Lötdüsen durchgriffen wird. Nach einer weiteren Ausführungsform ist die Prallplatte im Wesentlichen horizontal, das heißt im wesentlichen parallel zum Lotspiegel im Schmelztiegel, angeordnet oder leicht geneigt ausgebildet. Eine leichte Neigung ermöglicht dabei insbesondere ein kontrolliertes Ableiten des Lotes von der Prallplatte zurück in den Schmelztiegel.

Um ein unkontrolliertes Abfließen des Lotes von der Prallplatte zu vermeiden, kann nach einem weiteren Ausführungsbeispiel die Prallplatte von einem über die Ebene der Prallplatte in Richtung zur Lötspitze hin überstehenden Rand begrenzt werden. Dabei kann der Rand die Prallplatte im wesentlichen geschlossen umlaufen oder aber nur abschnitts- oder bereichsweise an der Prallplatte ausgebildet sein.

Zur sicheren Ableitung des auf der Prallplatte auftreffenden Lotes kann ferner in der Prallplatte und/oder im Rand mindestens eine Ablauföffnung für das Lot vorgesehen sein. Im einfachsten Fall handelt es sich dabei um eine durchgehende Ablauföffnung in der Platte oder eine Kerbe im Rand.

Um ein sicheres Ablaufen des Lotes in den Schmelztiegel zu erreichen und eine Spritzerbildung sicher zu verhindern ist nach einer weiteren Ausführungsform unterhalb der Ablauföffnung mindestens ein Fallrohr zur Ableitung des Lotes angeordnet. Dabei kann das Fallrohr sich bis kurz über den Spiegel des schmelzflüssigen Lotes im Tiegel erstrecken oder sogar in das Lot zumindest geringfügig eintauchen.

Es ist eine Mehrzahl von Lotdüsen in beliebiger Anordnung vorgesehen, die jeweils einzeln oder in Gruppen angeordnet sein können. Dabei weist die Prallplatte eine Mehrzahl von Ausnehmungen auf, die von den Lötdüsen durchgriffen werden.

Um insbesondere die Ableiteinrichtung an unterschiedliche Lötbedingungen oder Leiterplattenkonfigurationen anpassen zu können, kann nach einer weiteren Ausführungsform eine Stelleinrichtung vorgesehen sein, mit der der Abstand der Prallplatte zur Spitze der Lötdüsen und damit auch die Höhe der Prallplatte über dem Lotspiegel im Schmelztiegel einstellbar ist.

Im einfachsten Fall weist dabei die Stelleinrichtung mindestens eine Stellschraube auf, die die Prallplatte durchgreift und am Träger mittelbar oder unmittelbar sich abstützend zur Anlage gelangt.

Um bei einem Einsatz der erfindungsgemäßen Vorrichtung unter Schutzgasatmosphäre den Verbrauch von Schutzgas zu minimieren, kann nach einem weiteren Ausführungsbeispiel der Erfindung mindestens eine die Ableiteinrichtung und die Lötdüse bzw. die Mehrzahl der Lötdüsen um- oder übergreifende Begasungskappe zur Einleitung eines Schutzgases an den zu lötenden Bereich der Leiterplatte vorgesehen sein.

Im Folgenden wird die Erfindung anhand lediglich Ausführungsbeispiele darstellender Zeichnungen näher erläutert.

Es zeigt:
- **Fig. 1**: in schematischer Schnittdarstellung ein erstes Ausführungsbeispiel der Erfindung mit aufgesetzter Ableiteinrichtung;
- **Fig. 2**: die Lötdüsenanordnung des Ausführungsbeispiels nach Fig. 1 in perspektivischer Darstellung ohne Ableiteinrichtung;
- **Fig. 3**: die Ableiteinrichtung des Ausführungsbeispiels nach Fig. 1 in einer der Fig. 2 entsprechenden Darstellung;
- **Fig. 4**: die Lötdüsenanordnung nach Fig. 2 mit aufgesetzter Ableiteinrichtung nach Fig. 3;
- **Fig. 5**: eine Lötdüsenanordnung nach einem zweiten Ausführungsbeispiel der vorliegenden Erfindung mit aufgesetzter Ableiteinrichtung;
- **Fig. 6**: die Ableiteinrichtung des Ausführungsbeispiels nach Fig. 5;
- **Fig. 7**: in schematischer perspektivischer Schnittdarstellung ein nicht beanspruchtes Beispiels einer Lötvorrichtung mit aufgesetzter Ableiteinrichtung;
- **Fig. 8**: die Ableiteinrichtung des Beispiels nach Fig. 7 in vergrößerter Darstellung.

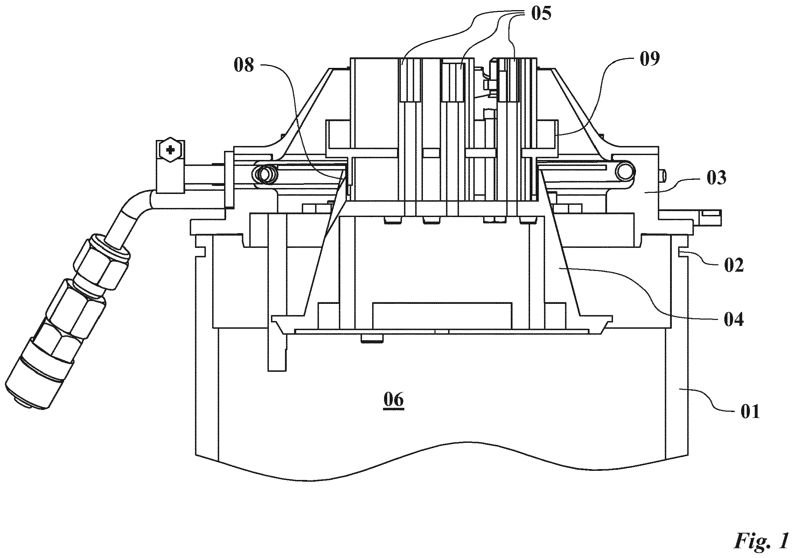

Die in Fig. 1 dargestellte Vorrichtung zum Löten von elektrischen oder elektronischen Bauteilen weist einen Lottiegel 01 auf, der an seinem oberen Kragen 02 von einem Deckel 03 verschlossen wird. Am Deckel 03 ist ein Träger 04 angeordnet, auf dem eine Mehrzahl von Lötdüsen 05 so angeordnet ist, dass zunächst im Lottiegel 01 befindliches schmelzflüssiges Lot 06 über eine nicht dargestellte Fördereinrichtung aus dem Lottiegel 01 zu den Lötdüsen 05 förderbar ist.

Der Strom schmelzflüssigen Lotes 06 tritt an der oberen Stirnseite der Lötdüsen 05 aus, benetzt die Lotpins der auf einer Leiterplatte angeordneten elektrischen oder elektronischen Bauteile und stellt so nach dem Erstarren eine feste und insbesondere elektrisch leitende Lötverbindung her. Überschüssiges Lot fließt aufgrund der Schwerkraft nach unten mittelbar oder unmittelbar zurück in den Lottiegel 01.

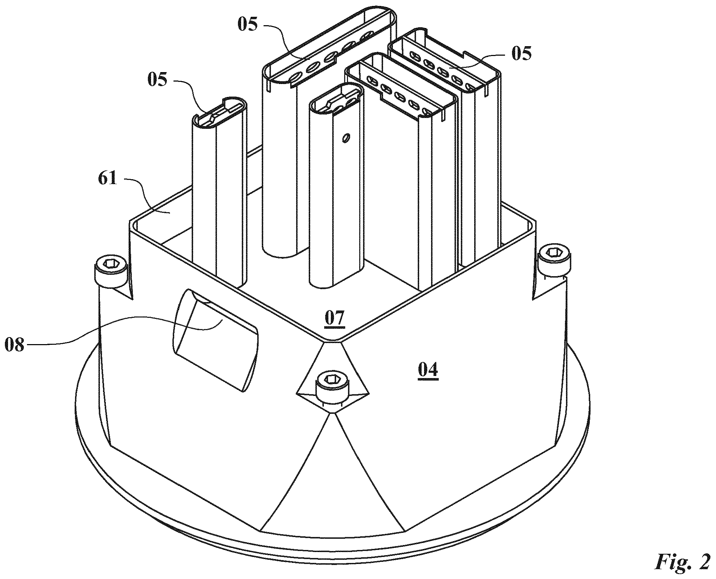

Wie insbesondere aus Fig. 2 ersichtlich ist, weist der Träger 04 bei diesem Ausführungsbeispiel im wesentlichen die Form eines Pyramidenstumpfs mit einer Trägerplatte 07, auf der die Lötdüsen 05 angeordnet sind, auf, wobei die Trägerplatte 07 durch einen im wesentlichen geschlossen umlaufenden Rand 61 begrenzt wird. Von den Lötdüsen 05 abfließendes überschüssiges Lot, das auf den Träger 04 gelangt, kann über im Rand der Trägerplatte 07 angeordnete Ausnehmungen 08 zurück in den Löttiegel 01 fließen. Da die Fallhöhe für das schmelzflüssige Lot von den Düsenspitzen auf die Trägerplatte 07 vergleichsweise hoch ist, besteht die Gefahr der Bildung von Lotspritzern, die, wenn sie an die Unterseite der Leiterplatte gelangen, die Gefahr von Lötfehlern durch beispielsweise unerwünschte Brückenbildung zwischen benachbarten Lötpins bergen.

Um diese Gefahr zu vermeiden ist erfindungsgemäß zwischen den Spitzen der Lötdüsen 05 und dem Träger eine Ableiteinrichtung 09 angeordnet. Die Ableiteinrichtung 09 weist dabei eine tellerartige Prallplatte 10 auf, die von einem geschlossen umlaufenden Rand 11 begrenzt wird. Die Prallplatte 11 weist Ausnehmungen 12, 13 und 14 auf, die in Anordnung und Gestalt im wesentlichen der Anordnung und der Außenkontur der Lötspitzen 05 entsprechen.

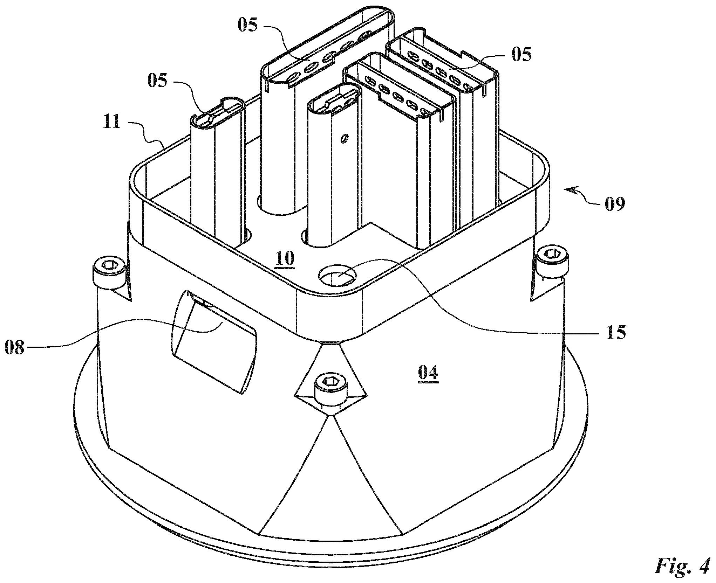

Wie insbesondere aus Fig. 4 ersichtlich ist, kann die Ableiteinrichtung 09 so auf die Lötdüsenanordnung aufgesetzt werden, dass die Prallplatte 10 die Lötdüsen 05 im wesentlichen formschlüssig umgreift und die Ableiteinrichtung 09 insgesamt zwischen den Spitzen der Lötdüsen 05 und dem Träger 04 angeordnet ist, wobei sich die Ableiteinrichtung auf dem Träger 04 abstützt. Fließt nun überschüssiges schmelzflüssiges aus den Spitzen der Lötdüsen austretendes Lot schwerkraftbeaufschlagt nach unten, gelangt es zunächst auf die Prallplatte 10 der Ableiteinrichtung 09. Aufgrund des im Vergleich des Abstandes zwischen Trägerplatte 07 und Lötdüsenspitzen deutlich geringeren Abstandes zwischen Prallplatte 10 und Lötdüsenspitzen kann dabei die Bildung unerwünschter Lotspritzer nahezu vollständig ausgeschlossen werden.

Das auf die Prallplatte 10 abfließende Lot wird durch eine weitere Ablauföffnung 15 auf die Trägerplatte 07 abgeleitet und kann von dort über die Ausnehmungen 08 zurück in den Lottiegel geführt werden. Der Abstand zwischen Trägerplatte 07 und Prallplatte 10 ist dabei ohne Belang, da eventuell beim Abfließen des Lotes von der Prallplatte 10 auf die Trägerplatte 07 entstehende Spritzer durch die Prallplatte gegenüber der Leiterplatte abgeschirmt werden.

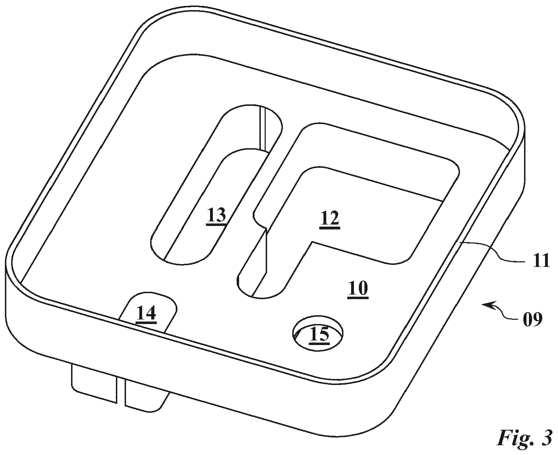

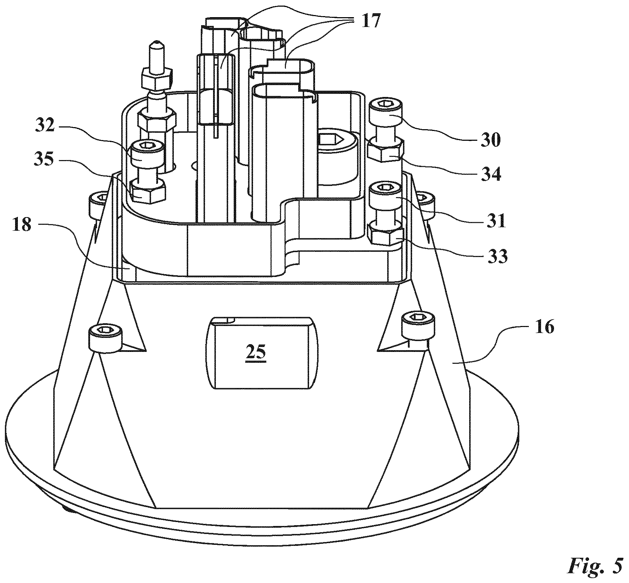

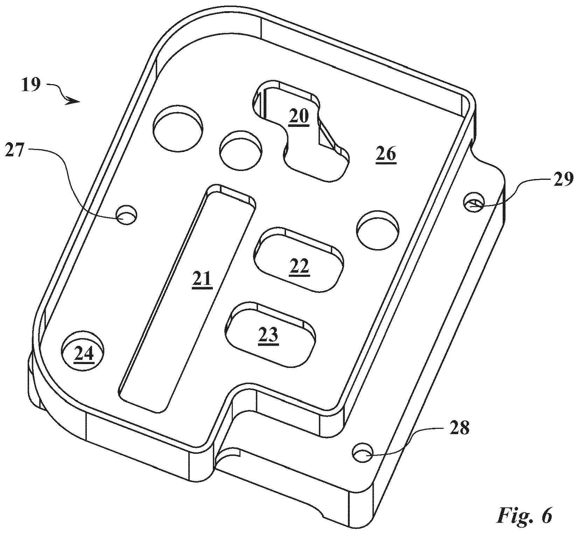

Das in den Figuren 5 und 6 dargestellte Ausführungsbeispiel weist grundsätzlich den gleichen Aufbau auf, wie das Ausführungsbeispiel nach den Figuren 1 bis 4. Der Träger 16 entspricht in Funktion und Aufbau dem Träger 04 nach der vorstehend beschriebenen Ausführungsform. Eine Mehrzahl von Lötdüsen 17 ist auf der Trägerplatte 18 des Trägers 16 angeordnet. Eine Ableiteinrichtung 19 weist ebenfalls Ausnehmungen 20, 21, 22 und 23 auf, über die die Ableiteinrichtung die Lötdüsen 17 umgreifend auf die Lötdüsenanordnung aufsteckbar ist. Überschüssiges Lot kann durch die Ablauföffnung 24 nach unten auf die Trägerplatte 18 und von dort über die Ausnehmung 25 in den Lottiegel abfließen.

Wie insbesondere aus Fig. 6 ersichtlich ist, ist die Ableiteinrichtung 19 mit einer Stelleinrichtung versehen, mit der der Abstand der Prallplatte 26 zu den Spitzen der Lötdüsen 17 einstellbar ist. Diese Stelleinrichtung weist Gewindebohrungen 27, 28 und 29 in der Ableiteinrichtung 19 auf, in die die Stellschrauben 30, 31 und 32 so einschraubbar sind, dass sie aus der Ableiteinrichtung 19 nach unten Richtung Trägerplatte 18 hervorstehen und mit jeweils mit der Schaftspitze die Ableiteinrichtung 19 abstützend an der Trägerplatte zur Anlage gelangen. Durch Verstellen der Stellschrauben 30, 31 und 32 kann dabei in einfacher Weise der Abstand zwischen den Spitzen der Lötdüsen 17 und der Prallplatte 26 eingestellt werden. Über Kontermuttern 33, 34 und 35 lässt sich die Position der Stellschrauben 30, 31 und 32 feststellen und diese damit sichern.

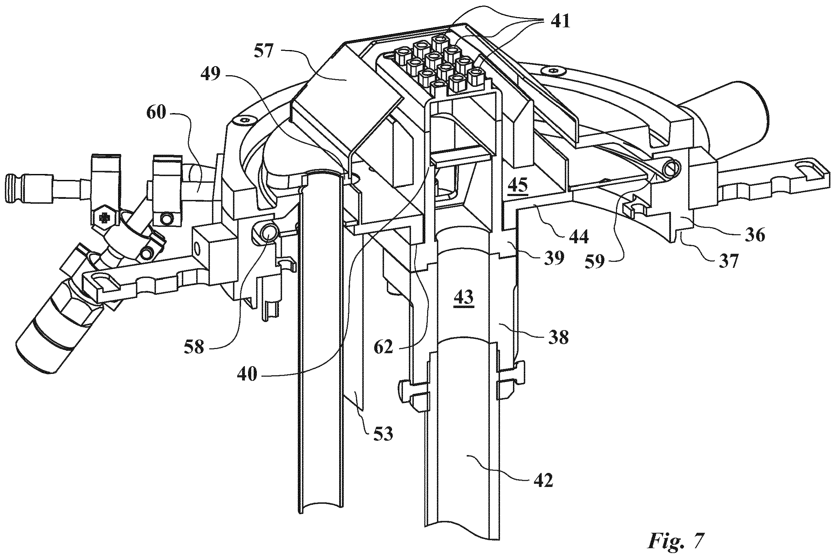

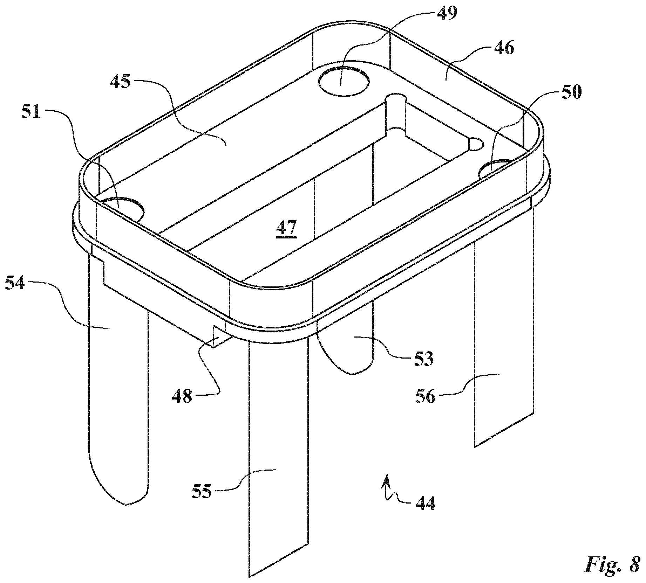

Ein nicht beanspruchtes Beispiel einer Lötvorrichtung ist in den Figuren 7 und 8 dargestellt. Die in Fig. 7 dargestellte Vorrichtung weist einen Deckel 36 auf, der mit seinem Rand 37 auf den Kragen eines nicht dargestellten Löttiegels aufsetzbar ist und diesen abdichtet. Im Deckel 36 ist eine Lötdüsenanordnung angeordnet, die einen Träger 38 aufweist, der eine Lötdüse 39 trägt. Die Lötdüse besteht bei diesem Beispiel aus einem Düsenkörper 40, der im Bereich seines oberen Endes eine Vielzahl von Düsenöffnungen 41 aufweist. Der Träger 38 ist an seinem unteren Ende mit einem Steigrohr 42 verbunden, über das mittels einer Fördereinrichtung schmelzflüssiges Lot durch eine zentrale Ausnehmung 43 im Träger 38 zu den Düsenöffnungen 41 gefördert werden kann.

Zwischen dem Träger 38 und den Düsenöffnungen 41 ist eine Ableiteinrichtung 44 angeordnet wie sie aus der Fig. 8 näher ersichtlich ist. Die Ableiteinrichtung 44 weist in ähnlicher Weise wie die vorstehend beschriebenen Ableiteinrichtungen 09 und 19 eine Prallplatte 45 auf, die durch einen geschlossen umlaufenden Rand 46 begrenzt wird. Die Prallplatte 45 ist mit einer Ausnehmung 47 versehen, die in ihren Abmessungen im wesentlichen der Außenkontur des Düsenkörpers 40 entspricht, so dass die Ableiteinrichtung den Düsenkörper 40 im wesentlichen formschlüssig umgreifend auf diesen aufsteckbar ist. Dabei gelangt die Ableiteinrichtung mit einem die Ausnehmung 47 umgreifenden flanschartigen Rand 48 an einem Absatz 62 des Düsenkörpers 40 sich abstützend zur Anlage.

Weiter weist die Prallplatte bei diesem Ausführungsbeispiel eine Mehrzahl von durchgehenden Ablauföffnungen 49, 50, 51 und 52 auf, durch die überschüssiges auf die Prallplatte 45 abfließendes Lot zurück in den Lottiegel abfließen kann. Unterhalb jeder Ablauföffnung 49, 50, 51 und 52 ist jeweils ein Fallrohr 53, 54, 55 und 56 angeordnet, das sich bis unterhalb des Lotspiegels im Lottiegel erstrecken oder aber geringfügig oberhalb des Lotspiegels enden kann.

Wie weiter aus Fig. 7 ersichtlich ist, ist eine dachartige Begasungskappe 57 vorgesehen, die sich in Richtung Düsenöffnungen verjüngt, so dass der freie Spalt um die Düsenöffnungen 41 möglichst gering gehalten werden kann. Über eine Gaszuführeinrichtung kann Schutzgas, insbesondere Stickstoff, in den zwischen Begasungskappe 57, Ableiteinrichtung 44 und Düsenanordnung gebildeten Raum eingeleitet werden, um insbesondere eine unerwünschte Oxidation des schmelzflüssigen Lotes zu verringern. Beim vorliegenden Beispiel weist die Gaszuführeinrichtung einen Schlauch 58 aus einem porösen Glasfasermaterial auf, der in einem umlaufenden Ringspalt 59 des Deckels 36 angeordnet ist, der zum zwischen Begasungskappe 57, Ableiteinrichtung 44 und Düsenanordnung gebildeten Raum hin offen ist. Wird nun durch einen externen Schutzgasanschluss 60 Schutzgas in den Schlauch 58 geleitet, gelangt dieses durch die porösen Schlauchwände in den Raum.

## Patentansprüche

1. Vorrichtung zum Löten von elektrischen oder elektronischen Bauteilen auf einer Leiterplatte, mit einer Lötdüsenanordnung, die mindestens einen Träger (04, 16) aufweist, auf dem mindestens eine Lötdüse (05, 17) angeordnet ist, wobei die Lötdüsenanordnung oberhalb eines Löttiegels (01) angeordnet ist und wobei mittels einer Fördereinrichtung schmelzflüssiges Lot (06) aus dem Löttiegel (01) durch die Lötdüse (05, 17) an die zu lötenden Bauteile gefördert werden kann, aufweisend mindestens eine Ableiteinrichtung (09, 19) für aus der Lötdüse (05, 17) ausgetretenes überschüssiges Lot, die zwischen der Spitze der Lötdüse (05, 17) und dem Träger (04, 16) angeordnet ist,
**dadurch gekennzeichnet,**
**dass** die Ableiteinrichtung (09, 19) mindestens eine im wesentlichen ebene Prallplatte (10, 26) aufweist, die die Lötdüse (05, 17) im wesentlichen umgreift, wobei eine Mehrzahl von Lötdüsen (05, 17) vorgesehen ist und die Prallplatte (10, 26) eine Mehrzahl von Ausnehmungen (12-14, 20-23) aufweist, die von den Lötdüsen (05, 17) durchgriffen werden, und wobei die gesamte Prallplatte (10, 26) unterhalb der Spitzen der Lötdüsen und oberhalb des Trägers (04, 16) angeordnet ist.

2. Vorrichtung nach Anspruch 1,
**dadurch gekennzeichnet,**
**dass** die Prallplatte (10, 26) die Lötdüse (05, 17) im Wesentlichen formschlüssig umgreift.

3. Vorrichtung nach Anspruch 1 oder 2,
**dadurch gekennzeichnet,**
**dass** die Prallplatte (10, 26) im wesentlichen einstückig ausgebildet ist.

4. Vorrichtung nach einem der Ansprüche 1 bis 3,
**dadurch gekennzeichnet,**
**dass** die Prallplatte (10, 26) im Wesentlichen horizontal oder leicht geneigt ausgebildet ist.

5. Vorrichtung nach einem der Ansprüche 1 bis 4,
**dadurch gekennzeichnet,**
**dass** die Prallplatte (10, 26) zumindest bereichsweise von einem die Ebene der Prallplatte (10, 26) in Richtung zur Lötspitze hin überstehenden Rand (11) begrenzt wird.

6. Vorrichtung nach einem der Ansprüche 1 bis 5,
**dadurch gekennzeichnet,**
**dass** in der Prallplatte (10, 26) und/oder im Rand (11) mindestens eine Ablauföffnung (15, 24) für das Lot vorgesehen ist.

7. Vorrichtung nach Anspruch 6,
**gekennzeichnet durch**
mindestens ein unterhalb der Ablauföffnung (15, 24) angeordnetes Fallrohr zur Ableitung des Lotes.

8. Vorrichtung nach einem der Ansprüche 1 bis 7,
**dadurch gekennzeichnet,**
**dass** eine Stelleinrichtung (30-32) vorgesehen ist, mit der (30-32) der Abstand der Prallplatte (10, 26) zur Spitze der Lötdüse (5, 17) einstellbar ist.

9. Vorrichtung nach Anspruch 8,
**dadurch gekennzeichnet,**
**dass** die Stelleinrichtung mindestens eine Stellschraube (30-32) aufweist, die (30-32) die Prallplatte (10, 26) durchgreift und am Träger (16) sich abstützend zur Anlage gelangt.

10. Vorrichtung nach einem der Ansprüche 1 bis 9,
**gekennzeichnet durch**
mindestens eine die Ableiteinrichtung (09, 19) und die Mehrzahl der Lötdüsen (05, 17) um- oder übergreifende Begasungskappe zur Einleitung eines Schutzgases.

## Claims

1. Device for soldering electrical or electronic components on a printed circuit board, the device comprising a soldering nozzle arrangement that comprises at least one support (04, 16) on which at least one soldering nozzle (05, 17) is arranged, the soldering nozzle arrangement being arranged above a solder pot (01) and it being possible, by means of a conveyer apparatus, for molten solder (06) to be conveyed out of the solder pot (01) through the solder nozzle (05, 17) onto the components to be soldered, comprising at least one apparatus (09, 19) for conducting away excess solder discharged from the soldering nozzle (05, 17), which conduction apparatus is arranged between the tip of the soldering nozzle (05, 17) and the support (04, 16), **characterized in that** the conduction apparatus (09, 19) has at least one substantially planar baffle plate (10, 26) which substantially encompasses the soldering nozzle (05, 17), a plurality of soldering nozzles (05, 17) being provided and the baffle plate (10, 26) having a plurality of recesses (12-14, 20-23) through which the soldering nozzles (05, 17) pass, and the entire baffle plate (10, 26) being arranged underneath the tips of the soldering nozzles and above the support (04, 16).

2. Device according to claim 1, **characterized in that** the baffle plate (10, 26) encompasses the soldering nozzle (05, 17) in a substantially form-fitting manner.

3. Device according to claim 1 or claim 2, **characterized in that** the baffle plate (10, 26) is formed as a single piece.

4. Device according to any of claims 1 to 3, **characterized in that** the baffle plate (10, 26) is substantially horizontal or slightly inclined.

5. Device according to any of claims 1 to 4, **characterized in that** the baffle plate (10, 26) is delimited at least in regions by a rim (11) which protrudes beyond the plane of the baffle plate (10, 26) toward the soldering tips.

6. Device according to any of claims 1 to 5, **characterized in that** at least one drainage opening (15, 24) for the solder is provided in the baffle plate (10, 26) and/or in the rim (11).

7. Device according to claim 6, **characterized by** at least one downspout which is arranged underneath the drainage opening (15, 24) and is intended for conducting away the solder.

8. Device according to any of claims 1 to 7, **characterized in that** an adjusting apparatus (30-32) is provided, by means of which (30-32) the distance between the baffle plate (10, 26) and the tip of the nozzle (5, 17) can be adjusted.

9. Device according to claim 8, **characterized in that** the adjusting apparatus has at least one adjusting screw (30-32) which (30-32) passes through the baffle plate (10, 26) and comes to rest on the support (16) in a self-supporting manner.

10. Device according to any of claims 1 to 9, **characterized by** at least one gas treatment cap for introducing a shielding gas, which cap encompasses or overlaps the conduction apparatus (09, 19) and the plurality of soldering nozzles (05, 17).

## Revendications

1. Dispositif de brasage de composants électriques ou électroniques sur une carte de circuits imprimés, pourvu d'un ensemble de buses de brasage, qui présente au moins un support (04, 16) sur lequel au moins une buse de brasage (05, 17) est agencée, dans lequel l'ensemble de buses de brasage est agencé au-dessus d'un creuset de brasage (01) et dans lequel un métal d'apport de brasage (06) en fusion peut être transporté au moyen d'un dispositif de transport du creuset de brasage (01) aux composants à braser en passant par la buse de brasage (05, 17), le dispositif comprenant au moins un dispositif de déviation (09, 19) pour l'excédent de métal d'apport de brasage sorti de la buse de brasage (05, 17), lequel dispositif est agencé entre la pointe de la buse de brasage (05, 17) et le support (04, 16),
**caractérisé**
**en ce que** le dispositif de déviation (09, 19) présente au moins une plaque déflectrice (10, 26) sensiblement plate, qui entoure sensiblement la buse de brasage (05, 17), dans lequel une pluralité de buses de brasage (05, 17) sont prévues et la plaque déflectrice (10, 26) présente une pluralité d'évidements (12-14, 20-23) qui sont traversés par les buses de brasage (05, 17), et dans lequel la plaque déflectrice (10, 26) est entièrement agencée au-dessous des pointes des buses de brasage et au-dessus du support (04, 16).

2. Dispositif selon la revendication 1,
**caractérisé**
**en ce que** la plaque déflectrice (10, 26) entoure la buse de brasage (05, 17) sensiblement par coopération de formes.

3. Dispositif selon la revendication 1 ou 2,
**caractérisé**
**en ce que** la plaque déflectrice (10, 26) est réalisée sensiblement d'une seule pièce.

4. Dispositif selon l'une quelconque des revendications 1 à 3,
**caractérisé**
**en ce que** la plaque déflectrice (10, 26) est réalisée de manière sensiblement horizontale ou légèrement inclinée.

5. Dispositif selon l'une quelconque des revendications 1 à 4,
**caractérisé**
**en ce que** la plaque déflectrice (10, 26) est délimitée au moins par endroits par un bord (11) faisant saillie du plan de la plaque déflectrice (10, 26) en direction de la pointe de brasage.

6. Dispositif selon l'une quelconque des revendications 1 à 5,
**caractérisé**
**en ce qu'**au moins un orifice d'évacuation (15, 24) pour le métal d'apport de brasage est prévu dans la plaque déflectrice (10, 26) et/ou dans le bord (11).

7. Dispositif selon la revendication 6,
**caractérisé par**
au moins un tuyau de descente agencé au-dessous de l'orifice d'évacuation (15, 24) et destiné à dévier le métal d'apport de brasage.

8. Dispositif selon l'une quelconque des revendications 1 à 7,
**caractérisé**
**en ce qu'**un dispositif de réglage (30-32) est prévu, au moyen duquel (30-32) l'écart entre la plaque déflectrice (10, 26) et la pointe de la buse de brasage (05, 17) peut être réglé.

9. Dispositif selon la revendication 8,
**caractérisé**
**en ce que** le dispositif de réglage présente au moins une vis de réglage (30-32), qui (30-32) traverse la plaque déflectrice (10, 26) et parvient en contact avec le support (16) par appui.

10. Dispositif selon l'une quelconque des revendications 1 à 9,
**caractérisé par**
au moins un capuchon de gazage venant se plaquer autour ou au-dessus du dispositif de déviation (09, 19) et de la pluralité des buses de brasage (05, 17) et destiné à introduire un gaz de protection.
